# EUROPEAN PATENT APPLICATION

(11) **EP 2 278 345 A2**
(43) Date of publication of application: **26.01.2011**
(21) Application number: 10251215.9
(22) Date of filing: 06.07.2010
(51) Int. Cl.: G01R 15/20

(54) **A hall effect current sensor system and associated flip-chip packaging**

(30) Priority: 07.07.2009 US 223508 P
(71) Applicant: Monolithic Power Systems, Inc., San Jose, CA 95120-5000 (US)
(72) Inventor: Bakker, Anthonius, Morgan Hill, CA 95037 (US)
(74) Representative: Leach, James

(57) **Abstract**

A Hall effect current sensor system comprises a semiconductor die, a lead frame structure and a PCB board. The semiconductor die has Hall effect sensor (31) fabricated on it. The lead frame structure comprises at least two extended electrical leads. A conductor bar is printed on the PCB board. The two extended electrical leads and the conductor bar form a closed current path (30) for generating a direct magnetic field. When the Hall effect sensor (31) is inside the closed loop (30) of the current path, current information can be obtained.

## Description

This application claims priority to and the benefit of U.S. Provisional Patent Application No. 61/223,508, filed July 7, 2009 and titled FLIP-CHIP PACKAGING FOR HALL-EFFECT CURRENT SENSOR, which is incorporated herein by reference in its entirety.

The present invention generally relates to Hall effect current sensors, and more particularly but not exclusively to flip-chip packaging for Hall effect current sensors.

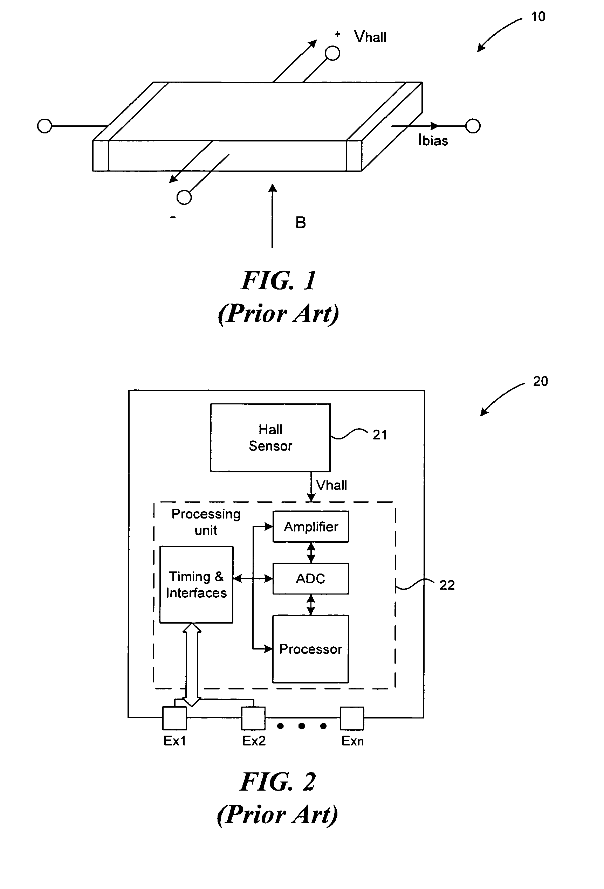

Magnetic fields can be directly sensed using a Hall effect sensor, which can be manufactured using CMOS (complementary metal oxide semiconductor) technology. A typical Hall effect sensor may consist of a suitably dimensioned lowly-doped semiconductor resistor. Figure 1 schematically illustrates the Hall effect, which is the generation of a potential difference Vhall (the Hall effect inductive voltage) across the electrical conductor 10, transverse to an electric current lbias in the conductor 10 and a magnetic field B perpendicular to lbias.

When current is flowing through a conductor, a magnetic field is generated around that conductor. The strength of the magnetic field is proportional to the current through the conductor. By placing a Hall effect sensor in the generated magnetic field, the current through the conductor can be sensed. This effect is used in Hall effect based current sensors.

A Hall effect current sensor can include additional components to determine the current information. A Hall effect current sensor can be fabricated on one die using CMOS technology. The die can include the Hall effect sensor, the timing and control units, the ADC (analog to digital converter) unit, the interfaces part and so on. The die may contain electrodes for current path and I/O signal transmission with external electrical circuits.

In one embodiment, a Hall effect current sensor system comprises a semiconductor die, a lead frame structure and a PCB board. The semiconductor die may have a Hall effect sensor fabricated on it. The lead frame structure may comprise at least two extended electrical leads. A conductor bar may be printed on the PCB board. The two extended electrical leads and the conductor bar may form a closed current path for generating a direct magnetic field. When the Hall effect sensor is inside the closed loop of the current path, current information can be obtained.

### BRIEF DESCRIPTION OF THE DRAWINGS

Figure 1 illustrates the Hall effect.

Figure 2 shows a block diagram of a Hall effect current sensor semiconductor die in accordance with an embodiment of the present invention.

Figure 3 illustrates the principle of Hall effect current sensing in accordance with an embodiment of the present invention.

Figure 4 shows a top plan view of a flip chip package that includes a lead frame structure where a flip chip Hall effect current sensor semiconductor die is received in accordance with an embodiment of the present invention.

Figure 5 shows a cross-sectional view of a Hall effect current sensor system in accordance with an embodiment of the present invention.

Figure 6 shows a flow diagram of a current sensing method according to an embodiment of the present invention.

Figure 2 shows a block diagram of a Hall effect current sensor semiconductor die 20 which is preferably accordance with an embodiment of the present invention. On the die 20, one or more Hall effect sensors 21 and a processing unit 22 are fabricated with CMOS compatible technology. A Hall effect sensor 21 senses the magnetic field around it and puts out an analog signal of Hall effect voltage to the processing unit 22. In one embodiment, the processing unit 22 figures out the magnitude of the magnetic field according to the Hall effect voltage. The processing unit 22 also figures out the current information of the targeted current source according to the Hall effect voltage and the position relationship between the Hall effect sensor 21 and the current source. In one embodiment, the processing unit 22 comprises a timing and interfaces circuit, an amplifier circuit, an ADC circuit and a processor circuit. The sensed analog signal of the inductive Hall effect voltage across the Hall effect sensor 21 is amplified by the amplifier circuit and converted into digital signal by the ADC circuit. The digital signal is processed by the processor circuit to take out some deduction such as digital slow chopper, decimation filter summation, Hall voltages averaging and so on to get the current information. The timing and interfaces circuit controls the amplifier circuit, ADC circuit and processor circuit, and, transmits signals between the Hall effect current sensor semiconductor die 20 and the external circuits through the input/output (I/O) electrodes Ex1, Ex2...Exn. The signals transmitted from the electrodes include the final current information of the targeted current source.

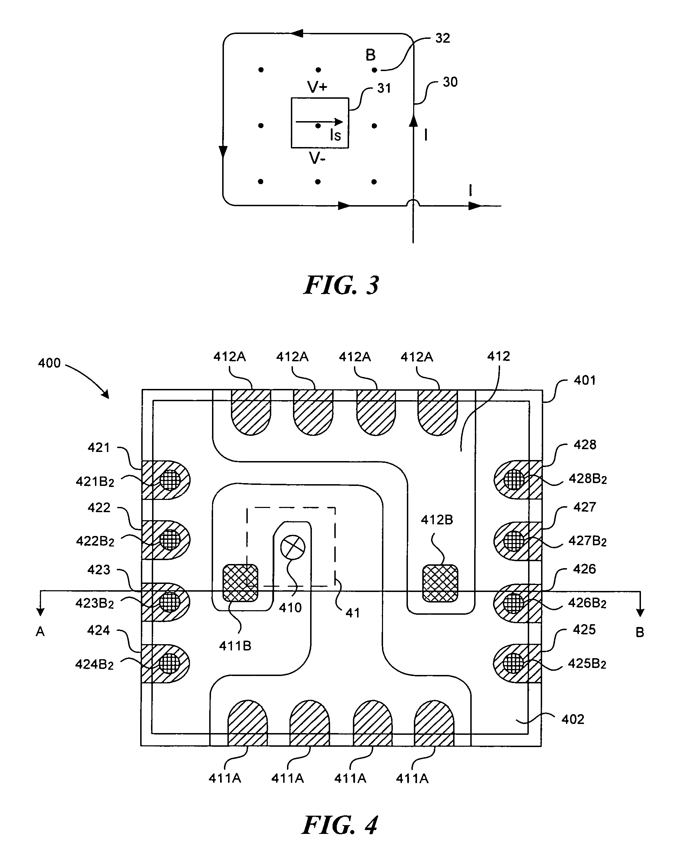

Figure 3 illustrates the principle of Hall effect current sensing according to one embodiment of the present invention. When the direct current I flows counterclockwise with a path forming a closed loop 30 as shown, a magnetic field B proportional to the magnitude of the direct current I is generated with orientation perpendicular to the page and outwards. A Hall effect sensor 31 is placed in the magnetic field B. With internal current Is flowing rightwards inside the Hall effect sensor 31, a Hall effect inductive voltage V+ to V- proportional to the magnitude of the magnetic field B and internal current Is is generated across the Hall effect sensor 31. For the present invention, in one embodiment, the closed loop 30 of the current path for the direct current I to be sensed is formed through the lead frame and the printed circuit board (PCB). From the inductive voltage of V+ to V-, the current I is calculated and sensed.

Now referring to Figure 4, a top plan view of a semiconductor flip chip device 400 for Hall effect current sensor is shown, which is preferably in accordance with an embodiment of the present invention. The semiconductor flip chip device 400 comprises a lead frame structure 401 and a semiconductor die 402, where the semiconductor die 402 is attached on the lead frame structure 401.

The lead frame structure 401 provides mechanical support and a means for electrical communication between the semiconductor die 402 and external circuits. The lead frame structure 401 also provides a path for the current to be sensed with certain position relationship to a Hall effect sensor 410 fabricated on the semiconductor die 402. In one embodiment, the lead frame structure 401 is one single metal frame made by any suitable method such as etching. The lead frame structure 401 includes several electrical leads 411, 412, 421-428. In the embodiment shown in Figure 4, the leads 411 and 412 form the inlet and outlet respectively for the current to be sensed.

Semiconductor die 402 can be a flip chip die with Hall effect sensor 410 fabricated on it. In one embodiment, the semiconductor die 402 is the same as the semiconductor die 20 illustrated in Figure 2. The semiconductor die 402 also has flip chip bumps 421 B2 -428B2 fabricated on the surface. In one particular example, the flip chip bumps 421B2 -428B2 are fabricated on the edge/edges of the die 402. The flip chip bumps 421 B2 -428B2 function as the electrodes Ex1-Exn shown in Figure 2.

A molding material encapsulates the semiconductor die 402 and the lead frame structure 401 to form the package while the contact pads 411A, 412A, 411B, 412B, 421-428 are exposed outside the molding materia! to contact with externa! circuit/circuits.

Continuing with Figure 4, the electrical leads 411 and 412 are of extended structures which take up a large area of the lead frame structure 401. At one end of the lead 411, pad/pads 411A are formed at the edge of the die 402 to function as the inlet/outlet of the to-be-sensed current. In order to form a closed loop 41 together with an external conductor bar, the electrical lead 411 has a crook shape. At the other end of the lead 411 near the Hall effect sensor 410, a connection pad 411B is fabricated. Meanwhile, at one end of the lead 412, pad/pads 412A are formed at the edge of the die 402 to function as the outlet/inlet of the to-be-sensed current and at the other end of the lead 412, connection pad 412B is fabricated. The extended electrical leads 411 and 412 form a loop shape with a gap. The loop is near the Hall effect sensor 410 and the Hall effect sensor 410 is inside the loop. The leads 411 and 412 of the lead frame structure further comprise connection pads 411B and 412B respectively at the opposite surface. When an external conductor bar fills up the gap with one end connected to the connection pad 411B and the other end connected to the connection pad 412B, the closed loop 41 for current path forms. In one embodiment, the external conductor bar is printed on a PCB board. In detail, the current to be sensed flows from the pad 411A into the lead 411 and then flows to the conductor bar printed on the PCB board through the connection pad 411B. Then, the current flows from the conductor bar into the lead 412 through the connection pad 412B. And the current finally flows out of the package through the pad 412A. In this way, the current to be sensed forms a closed loop 41 and generates a magnetic field in the "eye" of the loop 41. The Hall effect sensor 410 may be placed exactly in the center of the loop 41 and senses the magnetic field. Further, the magnitude of the current to be sensed can be obtained by calculation from the magnitude of the magnetic field and the position information. In another embodiment, the current to be sensed is provided from the pads 412A to 411A forming a clockwise path.

In one embodiment of the present invention, the lead frame structure 401 further includes a set of input/output electrical leads 421-428 which transmit signals between the semiconductor die 402 and the external circuits. Each electrical lead such as lead 421 has a bonding site where the bump 421B2 of the semiconductor die 402 makes contact with the electrical lead 421. The electrical leads 421-428 are connected to the electrodes Ex1 to Exn of the die 402 as illustrated in Figure 2 through the flip chip bumps 421 B2-428B2. The number of the input/output electrical leads is not limited to 8 which depends on the actual need of the Hall effect current sensor. The opposite surface (opposite to the surface contacting the die 402) of the input/output leads 421-428 forms the contact pads which are exposed at the surface of the molding compound. In one embodiment, the bumps are electrical contacts of copper pillar bumps. In another embodiment, the bumps can be electrical contacts of solder bumps.

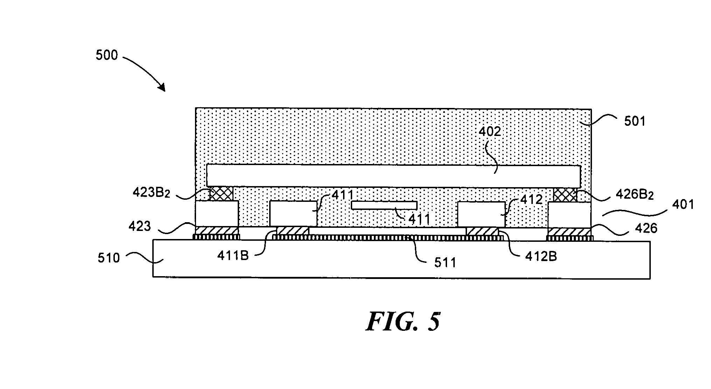

Now referring to Figure 5, there is shown a cross-sectional view of a Hall effect current sensor system 500 in accordance with an embodiment of the present invention. The Hall effect current sensor system 500 comprises the semiconductor flip chip device 400 and a board 510. This sectional view is along axis AB of the semiconductor flip chip device 400 shown in Figure 4. In detail, the Hall effect current sensor system 500 comprises the semiconductor die 402, the lead frame structure 401 and the board 510. In one embodiment, the board 510 is a printed circuit board (PCB) 510. On the lead frame structure 401, a semiconductor flip chip die 402 is faced down and contacts the lead frame structure 401 (including 423, 411, 412 and 426 etc.) with bumps (423B2 and 426B2, etc.); thus, signals are transmitted between the flip chip die 402 and the electrical leads (423 and 426, etc.) of the lead frame structure 401. The flip chip die 402 and the lead frame structure 401 are encapsulated by molding compound 501, leaving the bottom surfaces of the leads (423 and 426, etc.) exposed at the surface of the molding material 501 to function as the contact pads. In one embodiment, the contact pads of the electrical leads (423 and 426, etc.) are connected to the PCB board 510.

Referring again to Figure 5, the electrical leads 411 and 412 are connected to the board 510 by way of the connection pads 411B and 412B. In one embodiment, the connection pads 411B and 412B comprise part of the lead frame structure 401. Since the electrical lead 411 has a crook shape, the single electrical lead 411 is presented in two parts in the sectional view of Figure 5. On the PCB board 510, a conductor bar 511 is formed. In one embodiment, the conductor bar 511 is a copper layer printed on the PCB board 510. The conductor bar 511 is connected to the lead frame structure 401 at the connection pad 411B of the electrical lead 411 and at the connection pad 412B of the electrical lead 412. Thus, the electrical lead 411, the conductor bar 511 and the electrical lead 412 form a closed loop 41 as shown in Figure 4. A current path is formed for the to-be-sensed current flowing from 411A to 412A through the conductor bar 511 and forms a current loop. In one embodiment, the Hall effect sensor 410 on the flip chip die 402 is placed at the center of the closed loop 41. In another embodiment, the Hall effect sensor is placed inside the closed loop 41 not confined in the center. Current information can also be obtained with particular calculation according to the predetermined position relationship between the sensor/sensors and the current path. The term "center" means the sensor/sensors is at the center of the closed loop from the top plane view as shown in Figure 4. The term "inside" means the sensor/sensors is inside the closed loop from the top plane view as shown in Figure 4.

In one embodiment, the closed loop 30 for current path as shown in Figure 3 comprises more than two electrical leads of a lead frame structure and more than one conductor bar on a board. The multiple electrical leads are connected to the conductor bars in serial in the order of the first electrical lead, the first conductor bar, the second electrical lead, the second conductor bar and so forth to the last electrical lead where the first electrical lead and the last electrical lead are the inlet and the outlet of the current to be sensed.

The lead frame structure 501 as shown is leadless package such as quad flat leadless surface mount (QFN). It can also be leaded type package such as small outline package (SSOP) or others.

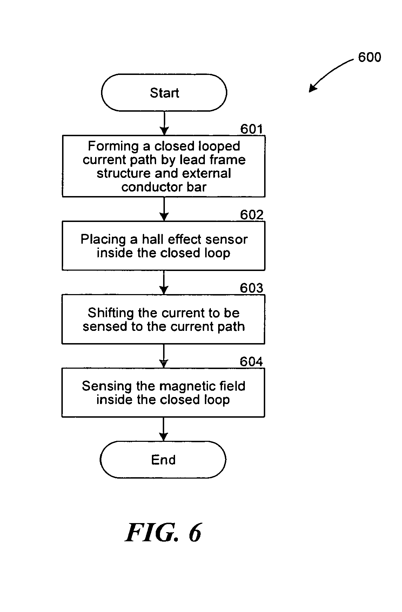

Figure 6 shows a flow diagram of a current sensing method according to an embodiment of the present invention. The method comprises at the first step 601 forming a current path having a closed loop and the current path is formed by lead frame structure and PCB board. In one particular example, the closed current path is formed by two extended electrical leads of the lead frame structure and an external conductor bar printed on a PCB board. At the second step 602, placing a Hall effect sensor inside the closed loop. In a typical example, the Hall effect sensor is fabricated on a flip chip semiconductor die attached on the lead frame structure in step 601. At the third step 603, the current to be sensed is flowed through the current path with current flowing into the inlet of the current path and flowing out of the outlet of the current path. At the forth step 604, current information is obtained by sensing the magnetic field inside the closed loop generated by the current to be sensed.

For the embodiments set forth in Figure 4 and Figure 5, the area of the extended electrical leads 411 and 412 consumes a large part of the lead frame structure, and the resistance of the current path is substantially low. In one particular example, the two extended electrical leads 411 and 412 take up more than half the area of the lead frame structure 401. Thus, power consumption of this current sensing approach is relatively low.

From the foregoing, it will be appreciated that specific embodiments of the disclosure have been described herein for purposes of illustration, but that various modifications may be made without deviating from the disclosure. Certain aspects of the disclosure described in the context of particular embodiments may be combined or eliminated in other embodiments. Not all embodiments need necessarily exhibit such advantages to fall within the scope of the disclosure. Accordingly, the disclosure is not limited except as by the appended claims.

From the foregoing, it will be appreciated that specific embodiments of the invention have been described herein for purposes of illustration, but that various modifications may be made without deviating from the spirit and scope of the invention. Accordingly, the invention is not limited except as by the appended claims.

The following statements provide general expressions of the disclosure herein.
A. A Hall effect current sensor system, comprising:
   a semiconductor die comprising at least one Hall effect sensor;
   a lead frame structure comprising at least two electrical leads, said semiconductor die being on the lead frame structure; and
   a board comprising at least one conductor bar, said board being connected to said lead frame structure, wherein the at least two electrical leads and the at least one conductor bar form a closed loop current path and said at least one Hall effect sensor is inside said closed loop current path.
B. The sensor system of statement A wherein said semiconductor die is a flip chip semiconductor die.
C. The sensor system of statement A wherein said at least two electrical leads comprise two extended electrical leads.
D. The sensor system of statement A, wherein one of said at least two electrical leads has a crook shape.
E. The sensor system of statement D, wherein said board comprises a single conductor bar.
F. The sensor system of statement E, wherein said single conductor bar is printed on said board.
G. The sensor system of statement A, wherein said semiconductor die comprises one Hall effect sensor.
H. The sensor system of statement A, wherein said at least one Hall effect sensor is at the center of said closed loop current path.
I. The sensor system of statement A further comprising molding material encapsulating said semiconductor die and said lead frame structure.
J. The sensor system of statement I, wherein said semiconductor die and said lead frame structure is encapsulated in QFN package.
K. The sensor system of statement A, wherein said semiconductor die further comprises processing unit and input/output electrodes.
L. The sensor system of statement K wherein said processing unit comprises timing and interfaces circuit, amplifier circuit, ADC circuit and processor circuit.
M. The sensor system of statement K wherein said input/output electrodes are connected to said lead frame through flip chip bumps.
N. A semiconductor flip chip device, comprising:
   a lead frame structure comprising two extended electrical leads, one of said two extended electrical leads having a crook shape; and
   a flip chip semiconductor die comprising at least one Hall effect sensor, said flip chip semiconductor die being attached on said lead frame structure;
   wherein said two extended electrical leads form a loop, and said at least one Hall effect sensor is inside said loop.
O. The flip chip device of statement N further comprising an external conductor bar, said external conductor bar being connected to said two extended electrical leads wherein said two extended electrical leads and said external conductor bar form a closed loop.
P. The flip chip device of statement N wherein the flip chip device is encapsulated by molding material in QFN package.
Q. A lead frame structure comprising two extended electrical leads, one of said electrical lead having a crook shape, wherein said two extended electrical leads form a loop shape.
R. The lead frame structure of statement Q, wherein said two extended electrical leads take up more than half area of said lead frame structure.
S. A current sensing method, comprising:
   forming a closed current path through a lead frame structure and PCB board;
   placing a Hall effect sensor inside the closed current path;
   flowing current to be sensed through the current path; and
   obtaining information about the current to be sensed.

## Claims

1. A Hall effect current sensor system, comprising:
a semiconductor die comprising at least one Hall effect sensor;
a lead frame structure comprising at least two electrical leads, said semiconductor die being on the lead frame structure; and
a board comprising at least one conductor bar, said board being connected to said lead frame structure, wherein the at least two electrical leads and the at least one conductor bar form a closed loop current path and said at least one Hall effect sensor is inside said closed loop current path.

2. The sensor system of claim 1 wherein:
said semiconductor die is a flip chip semiconductor die; and/or
said at least two electrical leads comprise two extended electrical leads.

3. The sensor system of claim 1, wherein one of said at least two electrical leads has a crook shape.

4. The sensor system of claim 3, wherein said board comprises a single conductor bar.

5. The sensor system of claim 4, wherein said single conductor bar is printed on said board.

6. The sensor system of claim 1, wherein:
said semiconductor die comprises one Hall effect sensor; and/or
said at least one Hall effect sensor is at the center of said closed loop current path.

7. The sensor system of claim 1 further comprising molding material encapsulating said semiconductor die and said lead frame structure.

8. The sensor system of claim 7, wherein said semiconductor die and said lead frame structure is encapsulated in QFN package.

9. The sensor system of claim 1, wherein said semiconductor die further comprises processing unit and input/output electrodes.

10. The sensor system of claim 9 wherein:
said processing unit comprises timing and interfaces circuit, amplifier circuit, ADC circuit and processor circuit; and/or
said input/output electrodes are connected to said lead frame through flip chip bumps.

11. A semiconductor flip chip device, comprising:
a lead frame structure comprising two extended electrical leads, one of said two extended electrical leads having a crook shape; and
a flip chip semiconductor die comprising at least one Hall effect sensor, said flip chip semiconductor die being attached on said lead frame structure;
wherein said two extended electrical leads form a loop, and said at least one Hall effect sensor is inside said loop.

12. The flip chip device of claim 11 wherein:
the flip chip device further comprises an external conductor bar, said external conductor bar being connected to said two extended electrical leads wherein said two extended electrical leads and said external conductor bar form a closed loop; and/or
the flip chip device is encapsulated by molding material in QFN package.

13. A lead frame structure comprising two extended electrical leads, one of said electrical lead having a crook shape, wherein said two extended electrical leads form a loop shape.

14. The lead frame structure of claim 13, wherein said two extended electrical leads take up more than half area of said lead frame structure.

15. A current sensing method, comprising:
forming a closed current path through a lead frame structure and PCB board;
placing a Hall effect sensor inside the closed current path;
flowing current to be sensed through the current path; and
obtaining information about the current to be sensed.
